# EUROPEAN PATENT APPLICATION

(11) **EP 4 848 579 A1**
(43) Date of publication of application: **02.12.2026**
(21) Application number: 26180334.0
(22) Date of filing: 21.05.2026
(51) Int. Cl.: H03D 7/16, H04B 1/16

(54) **SUBSAMPLING RECEIVER WITH BASEBAND SAMPLING CIRCUIT**

(30) Priority: 29.05.2025 US 202519221939
(71) Applicant: Apple Inc., Cupertino, CA 95014 (US)
(72) Inventor: SRIVASTAVA, Ankit, San Diego (US); ZHAO, Yi, San Jose (US); NICK, Morteza, San Diego (US); SIGNOFF, David, M, Sunnyvale (US)
(74) Representative: COPA Copenhagen Patents

(57) **Abstract**

A receiver of an electronic device may input received signals of one or more antennas and quadrature clock signals for sampling the received signals. The received signals may have a radio frequency and the quadrature clock signals may have a baseband frequency less than the radio frequency. Dividing the radio frequency by the baseband frequency may result in an odd or nearly odd quotient. As such, the quadrature clock signals may approximately align with (e.g., approximately or nearly align with) an odd multiple of quadrature phases of the received signals based on the odd ratio (e.g., nearly odd ratio, approximately odd ratio) between the radio frequency and the baseband frequency. The receiver may sample the received signals using the quadrature clock signals. Accordingly, the receiver may fold or alias the received signals to the baseband frequency by sampling the received signals using the quadrature clock signals.

## Description

### BACKGROUND

The present disclosure relates generally to wireless communication, and more specifically to receivers of an electronic device.

In an electronic device, a receiver may receive signals having a radio frequency. The radio frequency of the received signals may be greater than an operating frequency of the electronic device. As such, the receiver may convert the received signals to a lower frequency signal to enable signal processing by the electronic device. However, the receiver may include components that occupy an excessive amount of area in the electronic device and/or consume an excessive amount of electrical power.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

In one embodiment, an electronic device includes an antenna that may receive a signal having a first frequency. The electronic device also includes a mixer coupled to the antenna. The mixer may receive multiple clock signals having a second frequency less than the first frequency. A third frequency may be an odd multiple of the second frequency, and the third frequency may be within a threshold frequency range from the first frequency. Additionally, the mixer may generate multiple baseband signals having the second frequency based on the signal and the clock signals.

In another embodiment, a receiver includes a multi-phase delay-locked loop (MDLL) that may generate multiple clock signals having a first frequency. The receiver also includes a mixer coupled to the MDLL. The mixer may receive the clock signals and a signal having a second frequency from an antenna. The mixer may also generate multiple baseband signals having the first frequency based on the signal and the clock signals. A third frequency may be an odd multiple of the first frequency. The third frequency may be within a threshold frequency range from the second frequency and the second frequency may be greater than the first frequency.

In yet another embodiment, a mixer includes a multi-phase delay-locked loop (MDLL) that may generate a first clock signal and a second clock signal having a first frequency. The mixer also includes an in-phase switched-capacitor mixer coupled to the MDLL. The in-phase switched-capacitor mixer may receive the first clock signal and a signal from an antenna. The signal has a second frequency greater than the first frequency. The in-phase switched-capacitor mixer may generate an in-phase baseband signal having the first frequency based on the signal and the first clock signal. Additionally, the mixer includes a quadrature switched-capacitor mixer coupled to the MDLL. The quadrature switched-capacitor mixer may receive the second clock signal and the signal. The quadrature switched-capacitor mixer may also generate a quadrature baseband signal having the first frequency based on the signal and the second clock signal.

Various refinements of the features noted above may exist in relation to various aspects of the present disclosure. Further features may also be incorporated in these various aspects as well. These refinements and additional features may exist individually or in any combination. For instance, various features discussed below in relation to one or more of the illustrated embodiments may be incorporated into any of the above-described aspects of the present disclosure alone or in any combination. The brief summary presented above is intended only to familiarize the reader with certain aspects and contexts of embodiments of the present disclosure without limitation to the claimed subject matter.

### BRIEF DESCRIPTION OF THE DRAWINGS

Various aspects of this disclosure may be better understood upon reading the following detailed description and upon reference to the drawings described below in which like numerals refer to like parts.
FIG. 1 is a block diagram of an electronic device, according to embodiments of the present disclosure;
FIG. 2 is a functional diagram of the electronic device of FIG. 1, according to embodiments of the present disclosure;
FIG. 3 is a block diagram of a subsampling receiver of the electronic device of FIG. 1, according to embodiments of the present disclosure;
FIG. 4 is a schematic diagram of a mixer of the subsampling receiver of FIG. 3 that may convert a received signal having a radio frequency to a lower frequency baseband signal by sampling the received signal with an odd division clock frequency of the radio frequency (e.g., a sampling frequency that results in an odd quotient when the radio frequency is divided by the sampling frequency), according to embodiments of the present disclosure;
FIG. 5A is a first frequency spectrum diagram illustrating a first baseband frequency of quadrature clock signals of the subsampling receiver of FIG. 4, where an odd multiple of the first baseband frequency aligns with a radio frequency of the received signals, according to embodiments of the present disclosure;
FIG. 5B is a second frequency spectrum diagram illustrating a second baseband frequency of the quadrature clock signals of the subsampling receiver of FIG. 4, where an odd multiple of the second baseband frequency falls within a frequency range near the received signals, according to embodiments of the present disclosure; and
FIG. 6 is a timing diagram illustrating folded received signals having a lower frequency by the mixer of the subsampling receiver of FIG. 4 based on sampling the received signals with an odd division clock frequency of the radio frequency, according to embodiments of the present disclosure.

### DETAILED DESCRIPTION OF SPECIFIC EMBODIMENTS

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features. Furthermore, the particular features, structures, or characteristics may be combined in any suitable manner in one or more embodiments. Use of the terms "approximately," "near," "about," "close to," and/or "substantially" should be understood to mean including close to a target (e.g., design, value, amount), such as within a margin of any suitable or contemplatable error (e.g., within 0.1 % of a target, within 1% of a target, within 5% of a target, within 10% of a target, within 25% of a target, and so on). Moreover, it should be understood that any exact values, numbers, measurements, and so on, provided herein, are contemplated to include approximations (e.g., within a margin of suitable or contemplatable error) of the exact values, numbers, measurements, and so on. Additionally, the term "set" may include one or more. That is, a set may include a unitary set of one member, but the set may also include a set of multiple members.

This disclosure is directed to a receiver of an electronic device. The receiver may receive signals from one or more antennas. The received signals may have a radio frequency greater than an operating frequency of the electronic device. As such, the receiver may convert the received signals to a lower frequency signal to enable signal processing by the electronic device. Moreover, the receiver may include components that occupy a reduced amount of area in the electronic device and/or consume a reduced amount of electrical power compared to other receivers.

The receiver may receive the received signals and quadrature clock signals (e.g., clock signal) having a baseband frequency less than the radio frequency. In particular, the baseband frequency may be equal to (e.g., approximately or nearly equal to) an odd division of the radio frequency instead of being equal to or near the radio frequency. For example, the radio frequency may approximately or nearly correspond to an odd multiple of the baseband frequency. That is, the odd division of the radio frequency may result in an approximately or nearly odd quotient (e.g., 3, 5, 7, 9, 11, and so on) when the radio frequency is divided by the baseband frequency. As such, the quadrature clock signals may align with (e.g., approximately or nearly align with) an odd multiple of quadrature phases of the received signals based on the odd ratio (e.g., nearly odd ratio, approximately odd ratio) between the radio frequency and the baseband frequency. Moreover, each quadrature clock signal may align with (e.g., approximately or nearly align with) an odd multiple of a respective quadrature phase of the received signals across the frequency domains. The receiver may sample the received signals using the quadrature clock signals. Accordingly, the receiver may fold or alias the received signals to the baseband frequency by sampling the received signals using the quadrature clock signals.

The receiver may not generate the quadrature clock signals with the radio frequency based on sampling the received signals using a lower baseband frequency compared to the radio frequency. As such, the receiver may have reduced electrical power consumption based on generating the quadrature clock signals with a reduced frequency (e.g., the baseband frequency) compared to other receivers. Moreover, the receiver may omit additional circuitry used to generate the quadrature clock signals with a greater frequency (e.g., the radio frequency) based on folding and/or aliasing the received signals using the baseband frequency instead of the radio frequency. As such, the receiver may occupy a reduced area and/or consume reduced electrical power compared to other receivers based on omitting the additional circuitry.

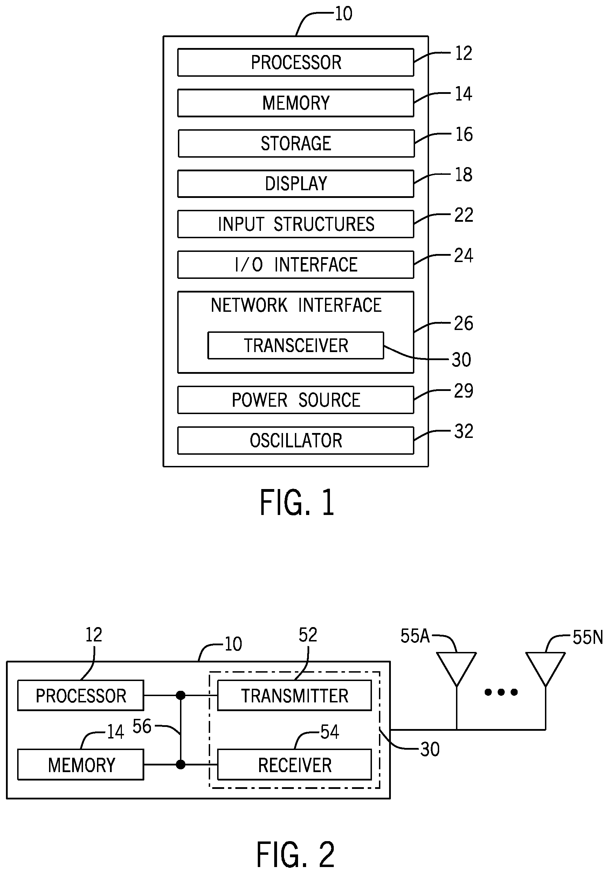

FIG. 1 is a block diagram of an electronic device 10, according to embodiments of the present disclosure. The electronic device 10 may include, among other things, one or more processors 12 (collectively referred to herein as a single processor for convenience, which may be implemented in any suitable form of processing circuitry), memory 14, nonvolatile storage 16, a display 18, input structures 22, an input/output (I/O) interface 24, a network interface 26, a power source 29, and an oscillator 32. The various functional blocks shown in FIG. 1 may include hardware elements (including circuitry), software elements (including machine-executable instructions) or a combination of both hardware and software elements (which may be referred to as logic). The processor 12, memory 14, the nonvolatile storage 16, the display 18, the input structures 22, the I/O interface 24, the network interface 26, the power source 29, and/or the oscillator 32 may each be communicatively coupled directly or indirectly (e.g., through or via another component, a communication bus, a network) to one another to transmit and/or receive signals between one another. It should be noted that FIG. 1 is merely one example of a particular implementation and is intended to illustrate the types of components that may be present in the electronic device 10.

By way of example, the electronic device 10 may include any suitable computing device, including a desktop or notebook computer, a portable electronic or handheld electronic device such as a wireless electronic device or smartphone, a tablet, a wearable electronic device, and other similar devices. In additional or alternative embodiments, the electronic device 10 may include an access point, such as a base station, a router (e.g., a wireless or Wi-Fi router), a hub, a switch, and so on. It should be noted that the processor 12 and other related items in FIG. 1 may be embodied wholly or in part as software, hardware, or both. Furthermore, the processor 12 and other related items in FIG. 1 may be a single contained processing module or may be incorporated wholly or partially within any of the other elements within the electronic device 10. The processor 12 may be implemented with any combination of general-purpose microprocessors, microcontrollers, digital signal processors (DSPs), field programmable gate array (FPGAs), programmable logic devices (PLDs), controllers, state machines, gated logic, discrete hardware components, dedicated hardware finite state machines, or any other suitable entities that may perform calculations or other manipulations of information. The processor 12 may include one or more application processors, one or more baseband processors, or both, and perform the various functions described herein.

In the electronic device 10 of FIG. 1, the processor 12 may be operably coupled with a memory 14 and a nonvolatile storage 16 to perform various algorithms. Such programs or instructions executed by the processor 12 may be stored in any suitable article of manufacture that includes one or more tangible, computer-readable media. The tangible, computer-readable media may include the memory 14 and/or the nonvolatile storage 16, individually or collectively, to store the instructions or routines. The memory 14 and the nonvolatile storage 16 may include any suitable articles of manufacture for storing data and executable instructions, such as random-access memory, read-only memory, rewritable flash memory, hard drives, and optical discs. In addition, programs (e.g., an operating system) encoded on such a computer program product may also include instructions that may be executed by the processor 12 to enable the electronic device 10 to provide various functionalities.

In certain embodiments, the display 18 may facilitate users to view images generated on the electronic device 10. In some embodiments, the display 18 may include a touch screen, which may facilitate user interaction with a user interface of the electronic device 10. Furthermore, it should be appreciated that, in some embodiments, the display 18 may include one or more liquid crystal displays (LCDs), light-emitting diode (LED) displays, organic light-emitting diode (OLED) displays, active-matrix organic light-emitting diode (AMOLED) displays, or some combination of these and/or other display technologies.

The input structures 22 of the electronic device 10 may enable a user to interact with the electronic device 10 (e.g., pressing a button to increase or decrease a volume level). The I/O interface 24 may enable electronic device 10 to interface with various other electronic devices, as may the network interface 26. In some embodiments, the I/O interface 24 may include an I/O port for a hardwired connection for charging and/or content manipulation using a standard connector and protocol, such as the Lightning connector, a universal serial bus (USB), or other similar connector and protocol.

The network interface 26 may include, for example, one or more interfaces for a personal area network (PAN), such as an ultra-wideband (UWB) or a BLUETOOTH network, a local area network (LAN) or wireless local area network (WLAN), such as a network employing one of the IEEE 802.11x family of protocols (e.g., WI-FI), and/or a wide area network (WAN), such as any standards related to the Third Generation Partnership Project (3GPP), including, for example, a 3^{rd} generation (3G) cellular network, universal mobile telecommunication system (UMTS), 4^{th} generation (4G) cellular network, Long Term Evolution (LTE) cellular network, Long Term Evolution License Assisted Access (LTE-LAA) cellular network, 5^{th} generation (5G) cellular network, and/or New Radio (NR) cellular network, a 6^{th} generation (6G) or greater than 6G cellular network, a satellite network, a non-terrestrial network, and so on. In particular, the network interface 26 may include, for example, one or more interfaces for using a cellular communication standard of the 5G specifications that include the millimeter wave (mmWave) frequency range (e.g., 24.25-300 gigahertz (GHz)) that defines and/or enables frequency ranges used for wireless communication. The network interface 26 of the electronic device 10 may allow communication over the aforementioned networks (e.g., 5G, Wi-Fi, LTE-LAA, and so forth).

The network interface 26 may also include one or more interfaces for, for example, broadband fixed wireless access networks (e.g., WIMAX), mobile broadband Wireless networks (mobile WIMAX), asynchronous digital subscriber lines (e.g., ADSL, VDSL), digital video broadcasting-terrestrial (DVB-T) network and its extension DVB Handheld (DVB-H) network, ultra-wideband (UWB) network, alternating current (AC) power lines, and so forth.

As illustrated, the network interface 26 may include a transceiver or modem 30. In some embodiments, all or portions of the transceiver 30 may be disposed within the processor 12. The transceiver 30 may support transmission and receipt of various wireless signals via one or more antennas, and thus may include a transmitter and a receiver. The power source 29 of the electronic device 10 may include any suitable source of power, such as a rechargeable lithium polymer (Li-poly) battery and/or an alternating current (AC) power converter.

In the depicted embodiment, the electronic device 10 may include the oscillator 32 to generate a reference clock signal. The oscillator 32 may include any viable circuitry to generate the reference clock signal. In some embodiments, the oscillator 32 may include one or more crystal oscillators, delay-locked loops (DLLs), among other things. Alternatively or additionally, the electronic device 10 may receive the reference clock signal from an external oscillator disposed external to the electronic device 10. For example, the external oscillator may be disposed on a separate electronic device coupled to the electronic device 10. The processor 12, memory 14, the nonvolatile storage 16, the display 18, the input structures 22, the I/O interface 24, the network interface 26, and/or the power source 29, among other things, may receive and use the reference clock signal.

FIG. 2 is a functional diagram of the electronic device 10 of FIG. 1, according to embodiments of the present disclosure. As illustrated, the processor 12, the memory 14, the transceiver 30, a transmitter 52, a receiver 54, and/or antennas 55 (illustrated as 55A-55N, collectively referred to as an antenna 55) may be communicatively coupled directly or indirectly (e.g., through or via another component, a communication bus, a network) to one another to transmit and/or receive signals between one another.

The electronic device 10 may include the transmitter 52 and/or the receiver 54 that respectively enable transmission and reception of signals between the electronic device 10 and an external device via, for example, a network (e.g., including base stations or access points) or a direct connection. As illustrated, the transmitter 52 and the receiver 54 may be combined into the transceiver 30. The electronic device 10 may also have the antennas 55A-55N electrically coupled to the transceiver 30. The antennas 55A-55N may be configured in an omnidirectional or directional configuration, in a single-beam, dual-beam, or multi-beam arrangement, and so on.

Each antenna 55 may be associated with one or more beams and various configurations. In some embodiments, multiple antennas of the antennas 55A-55N of an antenna group or module may be communicatively coupled to a respective transceiver 30 and each emit radio frequency signals that may constructively and/or destructively combine to form a beam. The electronic device 10 may include multiple transmitters, multiple receivers, multiple transceivers, and/or multiple antennas as suitable for various communication standards. In some embodiments, the transmitter 52 and the receiver 54 may transmit and receive information via other wired or wireline systems or means.

As illustrated, the various components of the electronic device 10 may be coupled together by a bus system 56. The bus system 56 may include a data bus, for example, as well as a power bus, a control signal bus, and a status signal bus, in addition to the data bus. The components of the electronic device 10 may be coupled together or accept or provide inputs to each other using some other mechanism.

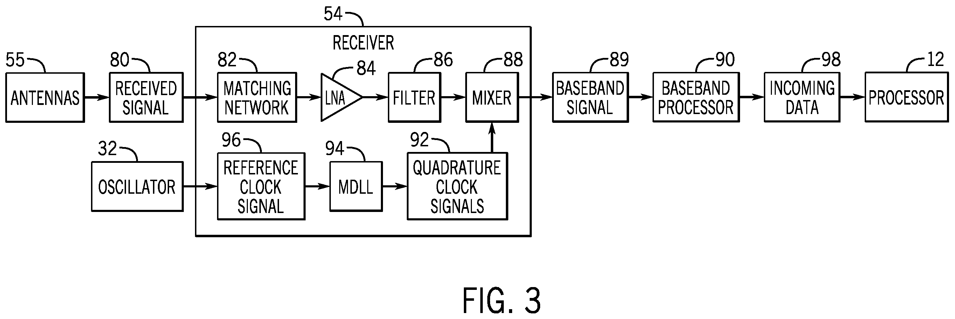

FIG. 3 is a schematic diagram of the receiver 54 (e.g., receive circuitry, a subsampling receiver), according to embodiments of the present disclosure. The one or more antennas 55 may receive received quadrature signal 80 in the form of an analog signal. The received quadrature signal 80, hereinafter referred to as the received signal 80, may have a radio frequency within any viable frequency range (e.g., 10 megahertz (MHz) or less, 124 MHz or less, 537 MHz or less, 1.1 GHz or less, 1.6 GHz or less, 10.1 GHz or less, 24.25 GHz or less, 300 GHz or less, 300 GHz or more, and so on) and/or associated with any viable network. As illustrated, the receiver 54 may receive the received signal 80 from the antenna 55.

In some embodiments, the receiver 54 may include a matching network 82 for receiving the received signal 80. In the depicted embodiment, the matching network 82 may include any viable circuitry, such as one or more resistors, capacitors, inductors, and/or transistors, to receive the received signal 80. In some cases, the matching network 82 may reduce undesired reflections of the received signal 80 and/or improve impedance matching of the receiver 54 and the antenna 55. The matching network 82 may output the received signal 80 to a low noise amplifier 84. It should be appreciated that in some embodiments, the receiver 54 may omit the matching network 82 or include a different circuit component in lieu or in addition to the matching network 82.

The low noise amplifier 84 may amplify the received signal 80 (e.g., received analog signals) to a suitable level for the receiver 54 to process. A filter 86 (e.g., filter circuitry and/or software) may remove undesired noise from the received signal 80, such as cross-channel interference. The filter 86 may also remove additional signals received by the antenna 55 that are at frequencies other than the desired signal. The filter 86 may include any suitable filter or filters to remove the undesired noise or signals from the received signal 80, such as a bandpass filter, a bandstop filter, a low pass filter, a high pass filter, and/or a decimation filter. The low noise amplifier 84 and/or the filter 86 may be referred to as part of the RFFE, and more specifically, a receiver front end (RXFE) of the electronic device 10. The low noise amplifier 84 and/or the filter 86 may output the received signal 80, as amplified and/or filtered.

A mixer 88 (e.g., a sampling circuit, a baseband sampling circuit) may receive the received signal 80, as amplified and/or filtered, and quadrature clock signals 92. The mixer 88 may sample the received signal 80 using the quadrature clock signals 92. For example, the mixer 88 may include switched-capacitor mixers, among other possibilities. The received signal 80 may have a radio frequency (e.g., a first frequency, a first frequency domain). The quadrature clock signals 92 may have a baseband frequency (e.g., a second frequency, a second frequency domain, a sampling frequency) less than the radio frequency.

The mixer 88 may convert, fold, or alias the received signal 80 to the baseband frequency by sampling the received signal 80 with the quadrature clock signals 92. As such, the mixer 88 may generate baseband signals 89 having the baseband frequency less than the radio frequency. The baseband frequency may be within a baseband frequency range. The baseband frequency range may correspond to any viable frequency range (e.g., 0.1 MHz or less, 1.2 MHz or less, 20 MHz or less, 249 MHz or less, 726 MHz or less, 1.1 GHz or less, 1.6 GHz or less, 10.1 GHz or less, 24.25 GHz or less, 24.25 GHz or more, and so on) less than the radio frequency.

The quadrature clock signals 92 may include multiple evenly phase-delayed (e.g., by 90 degrees, by approximately or nearly 90 degrees) clock signals. In the depicted embodiment, a multi-phase DLL 94 (MDLL) may generate the quadrature clock signals 92 with the baseband frequency equal to (e.g., approximately or nearly equal to) an odd division or factor of the radio frequency. That is, dividing the radio frequency by the baseband frequency may approximately or nearly result in an odd quotient. The quadrature clock signals 92 may align with (e.g., approximately or nearly align with) an odd multiple of quadrature phases of the received signal 80 based on an odd ratio (e.g., nearly odd ratio, approximately odd ratio) between the radio frequency and the baseband frequency.

For example, each quadrature clock signal 92 may align with (e.g., approximately or nearly align with) an odd multiple of a respective quadrature phase of the received signal 80. As such, the quadrature clock signals 92 may align with multiple phases of the received signal 80 across frequency domains. Accordingly, the mixer 88 may convert, fold, or alias the received signal 80 to the baseband frequency by sampling the received signal 80 with the quadrature clock signals 92. Moreover, the baseband signals 89 may have the baseband frequency that is less than the radio frequency.

The MDLL 94 may generate the quadrature clock signals 92 based on receiving a reference clock signal 96. In some embodiments, the oscillator 32 may generate the reference clock signal 96. For example, the oscillator 32 may include any viable circuitry to generate the reference clock signal 96. In alternative or additional embodiments, the MDLL 94 may receive a reference clock signal (e.g., the reference clock signal 96) from an external oscillator disposed external to the electronic device 10 for generating the quadrature clock signals 92.

The MDLL 94 may include any viable circuitry to adjust a frequency of a reference clock signal (e.g., the reference clock signal 96). For example, the MDLL 94 may include one or more buffers and/or inverters, one or more filters (e.g., low-pass filters), and/or a phase-frequency detector and/or charge pump, among things. The MDLL 94 may generate the quadrature clock signals 92 by converting a reference clock signal (e.g., the reference clock signal 96) to a frequency equal to (e.g., approximately or nearly equal to) an odd division of the radio frequency.

A baseband processor 90 may convert the baseband signals 89 to a digital signal of incoming data 98 to be further processed by the electronic device 10. The baseband processor 90 may include any viable circuitry or component to convert the baseband signals 89 to a digital signal of incoming data 98. For example, the processor 12 discussed above may include the baseband processor. Moreover, the baseband processor 90 may include an analog-to-digital converter receiving baseband signals 89 (e.g., analog signals) and converting the baseband signals 89 to a digital signal of the incoming data 98.

In some embodiments, the processor 12 discussed above may receive the incoming data 98 for further processing. It should be appreciated that in alternative or additional embodiments, the incoming data 98 may be received and/or processed by any other viable circuitry and/or component of the electronic device 10. Additionally, the receiver 54 may include any suitable additional components not shown, or may not include certain of the illustrated components, such that the receiver 54 may receive the received signal 80 via the antenna 55. For example, the receiver 54 may include a mixer, a digital down converter, and/or a demodulator, among other possibilities.

With the foregoing in mind, the receiver 54 may not generate the quadrature clock signals 92 with the radio frequency based on sampling the received signal 80 using the baseband frequency instead of the radio frequency. As such, the receiver 54 may have reduced electrical power consumption based on generating the quadrature clock signals 92 with a reduced frequency (e.g., the baseband frequency) compared to other receivers. In some embodiments, the receiver 54 may omit inclusion of an additional MDLL and/or a DLL for generating the quadrature clock signals 92 with a greater frequency (e.g., the radio frequency) based on folding and/or aliasing the received signal 80 using the baseband frequency instead of the radio frequency. As such, the receiver 54 may occupy a reduced area compared to other receivers based on omitting the additional MDLL and/or DLL. Additionally or alternatively, the receiver 54 may have reduced electrical power consumption based on omitting the additional MDLL and/or DLL.

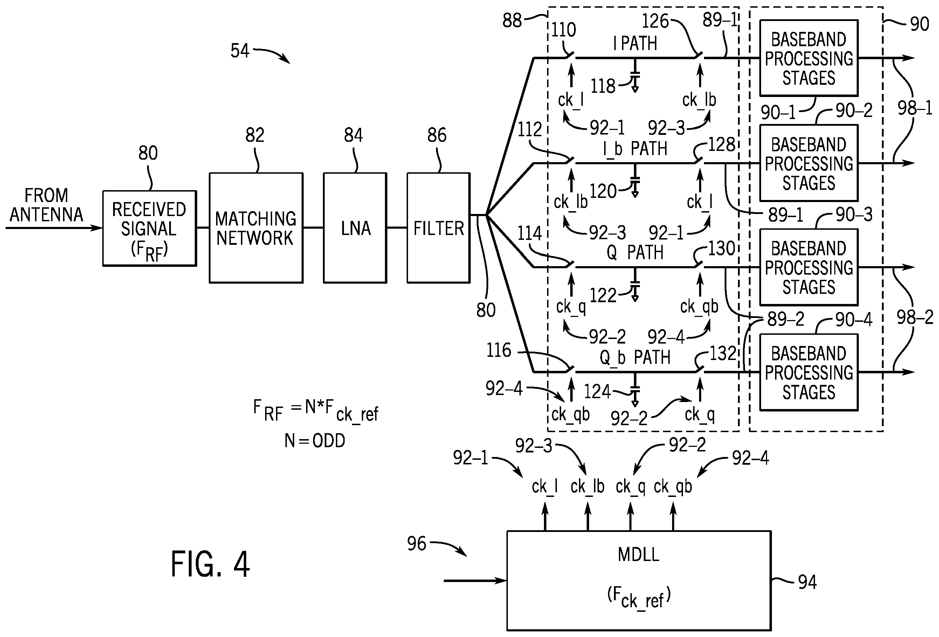

FIG. 4 is a schematic diagram of the mixer 88 of the receiver 54 converting or folding the received signal 80 having the radio frequency to lower frequency baseband signals 89 by sampling the received signal 80 with an odd division clock frequency of the radio frequency (e.g., a sampling frequency that results in an odd quotient or nearly or approximately and odd quotient when the radio frequency is divided by the lower baseband frequency), according to embodiments of the present disclosure. For example, the MDLL 94 may generate the quadrature clock signals 92 with the baseband frequency equal to (e.g., approximately or nearly equal to) an odd division of the radio frequency. Moreover, the quadrature clock signals 92 may align with (e.g., approximately or nearly align with) an odd multiple of quadrature phases of the received signal 80 based on the odd ratio (e.g., nearly odd ratio, approximately odd ratio) between the radio frequency and the baseband frequency. As such, the mixer 88 may convert, fold, and/or alias the received signal 80 having the radio frequency to the baseband frequency by sampling the received signal 80 with the quadrature clock signals 92 having the baseband frequency. Accordingly, the mixer 88 may generate baseband signals 89 having the baseband frequency less than the radio frequency.

As mentioned above, the matching network 82 may receive the received signal 80. The received signal 80 may include an in-phase (I) component or signal and a quadrature (Q) component or signal that are 90 degrees (e.g., approximately or nearly 90 degrees) out of phase. In some cases, the matching network 82 may reduce undesired reflections of the received signal 80 and/or improve impedance matching of the receiver 54 and the antenna 55. Moreover, the matching network 82 may output the received signal 80, including the I signal and the Q signal, to the low noise amplifier 84 and/or the filter 86.

The low noise amplifier 84 may amplify the received signal 80 to a suitable level for the receiver 54 to process. The filter 86 may reduce or remove undesired noises and/or undesired signals having frequencies other than the desired signal from the received signal 80. It should be appreciated that in some embodiments, the receiver 54 may not include one or more of the matching network 82, the low noise amplifier 84, and/or the filter 86. Moreover, in some embodiments, the receiver 54 may include additional circuitry and/or circuit components not shown in FIG. 4.

The mixer 88 may receive the received signal 80, as amplified and/or filtered, and quadrature clock signals 92. The quadrature clock signals 92 may include an in-phase (I) clock signal 92-1 (ck_I), a quadrature (Q) clock signal 92-2 (ck_q), an inverse I clock signal 92-3 (ck_lb), and an inverse Q clock signal 92-4 (ck_qb). The Q clock signal 92-2 may be 90 degrees (e.g., approximately or nearly 90 degrees) out of phase or delayed compared to the I clock signal 92-1. The inverse I clock signal 92-3 may be 180 degrees (e.g., approximately or nearly 180 degrees) out of phase or delayed compared to the I clock signal 92-1. The inverse Q clock signal 92-4 may be 270 degrees (e.g., approximately or nearly 270 degrees) out of phase or delayed compared to the I clock signal 92-1.

The mixer 88 may receive the received signal 80 with the radio frequency (e.g., the first frequency, F_{RF}). The quadrature clock signals 92, including the I/Q clock signals 92-1 and 92-2 and/or the inverse I/Q clock signals 92-3 and 92-4, may have a baseband frequency (e.g., the second frequency, F_{ck_ref}) less than the radio frequency. The MDLL 94 may generate the quadrature clock signals 92 with a baseband frequency equal to (e.g., approximately or nearly equal to) an odd division of the radio frequency (e.g., F_{RF}/N, where N is an odd number). That is, the radio frequency may be equal to (e.g., approximately or nearly equal to) an odd multiple of the baseband frequency (e.g., a third frequency, N*F_{ck_ref}). As such, an odd multiple of the quadrature clock signals 92 may approximately or nearly align with an odd multiple of quadrature phases of the received signal 80.

In some embodiments, the electronic device 10 and/or any viable circuitry and/or component of the electronic device 10 may dynamically determine and provide an indication of a baseband frequency to the MDLL 94. In alternative or additional embodiments, the MDLL 94 may be set to generate the quadrature clock signals 92 with a predetermined baseband signal based on the reference clock signal 96 during manufacturing. For example, the electronic device 10 and/or any viable circuitry and/or component of the electronic device 10, such as the processor 12, may receive or determine the baseband frequency and/or an odd multiple based on a clock frequency of the reference clock signal 96 and an expected or dynamically determined radio frequency of the received signal 80.

With the foregoing in mind, the quadrature clock signals 92 may align with (e.g., approximately or nearly align with) an odd multiple of quadrature phases of the received signal 80 based on the odd ratio (e.g., nearly odd ratio, approximately odd ratio, N) between the radio frequency and the baseband frequency. By way of example, the I clock signals 92-1 and 92-3 may nearly align with a first phase (e.g., 0 degrees, approximately 0 degrees) and a third phase (e.g., 180 degrees, approximately 180 degrees) of the received signal 80. Similarly, the Q clock signals 92-2 and 92-4 may nearly align with a second phase (e.g., 90 degrees, approximately 90 degrees) and a fourth phase (e.g., 270 degrees, approximately 270 degrees) of the received signal 80. As such, the mixer 88 may fold and/or alias the received signal 80 having the radio frequency to the baseband frequency by sampling the received signal 80 with the quadrature clock signals 92 having the baseband frequency.

In the depicted embodiment, the mixer 88 may include first switches 110, 112, 114, and 116, shunt capacitors 118, 120, 122, and 124, and second switches 126, 128, 130, and 132. The first switch 110, the shunt capacitor 118, and the second switch 126 may form a first switched-capacitor mixer for an I path (e.g., a first path). The first switch 112, the shunt capacitor 120, and the second switch 128 may form a second switched-capacitor mixer for an inverse I path (e.g., a second path, an I_b path). During operation, the first switched-capacitor mixer and the second switched-capacitor mixer may generate differential I baseband signals 89-1 (e.g., first baseband signals) by sampling the I signals or the first phase of the received signal 80 using the I clock signals 92-1 and 92-3. For example, the inverse I clock signal 92-3 may be 180 degrees (e.g., approximately or nearly 180 degrees) out of phase or delayed compared to the I clock signal 92-1. As such, the first switched-capacitor mixer and the second switched-capacitor mixer may generate the differential I baseband signals 89-1.

During the first phase of the received signal 80, the first switch 110 may receive the I clock signal 92-1 and the second switch 126 may receive the inverse I clock signal 92-3. As such, the I clock signal 92-1 may close the first switch 110 while the inverse I clock signal 92-3 may open the second switch 126 during the first phase of the received signal 80. Moreover, the shunt capacitor 118 may receive electrical currents and/or charges of the first phase of the received signal 80. The I clock signal 92-1 opens the first switch 110 and the inverse I clock signal 92-3 may close the second switch 126 during the third phase of the received signal 80. Accordingly, the shunt capacitor 118 may output the stored electrical currents and/or charges of the first phase of the received signal 80. In some cases, the shunt capacitor 118 may output the stored electrical currents and/or charges of the first phase during the third phase of the received signal 80.

During the third phase of the received signal 80, the first switch 112 may receive the inverse I clock signal 92-3 and the second switch 128 may receive the I clock signal 92-1. As such, the inverse I clock signal 92-3 may open the first switch 112 while the I clock signal 92-1 may close the second switch 126 during the third phase of the received signal 80. Moreover, the shunt capacitor 120 may receive electrical currents and/or charges of the third phase of the received signal 80. The inverse I clock signal 92-3 opens the first switch 112 and the I clock signal 92-1 may close the second switch 128 during a subsequent first phase of the received signal 80. As such, the shunt capacitor 120 may output the stored electrical currents and/or charges of the third phase of the received signal 80. Accordingly, the first switched-capacitor mixer and the second switched-capacitor mixer may generate the differential I baseband signals 89-1 with the baseband frequency. For example, the first switched-capacitor mixer and the second switched-capacitor mixer may form an I switched-capacitor mixer.

The first switch 114, the shunt capacitor 122, and the second switch 130 may form a third switched-capacitor mixer for a Q path (e.g., a third path). The first switch 116, the shunt capacitor 124, and the second switch 132 may form a fourth switched-capacitor mixer for an inverse Q path (e.g., a fourth path, a Q_b path). During operation, the third switched-capacitor mixer and the fourth switched-capacitor mixer may generate differential Q baseband signals 89-2 (e.g., second baseband signals) by sampling the Q signals or the second phase of the received signal 80 using the Q clock signals 92-2 and 92-4. By way of example, the inverse Q clock signal 92-4 may be 180 degrees (e.g., approximately or nearly 180 degrees) out of phase or delayed compared to the Q clock signal 92-2. As such, the third switched-capacitor mixer and the fourth switched-capacitor mixer may generate the differential Q baseband signals 89-2. For example, the third switched-capacitor mixer and the fourth switched-capacitor mixer may collectively referred to a Q switched-capacitor mixer.

During the second phase of the received signal 80, the first switch 114 may receive the Q clock signal 92-2 and the second switch 126 may receive the inverse Q clock signal 92-4. As such, the Q clock signal 92-2 may close the first switch 114 while the inverse Q clock signal 92-4 may open the second switch 130 during the second phase of the received signal 80. Moreover, the shunt capacitor 122 may receive electrical currents and/or charges of the second phase of the received signal 80. The Q clock signal 92-2 may open the first switch 114 and the inverse Q clock signal 92-4 may close the second switch 130 during the fourth phase of the received signal 80. Accordingly, the shunt capacitor 122 may output the stored electrical currents and/or charges of the second phase of the received signal 80. In some cases, the shunt capacitor 122 may output the stored electrical currents and/or charges of the second phase during the fourth phase of the received signal 80.

During the fourth phase of the received signal 80, the first switch 116 may receive the inverse Q clock signal 92-4 and the second switch 132 may receive the Q clock signal 92-2. As such, the inverse Q clock signal 92-4 may open the first switch 116 while the Q clock signal 92-2 may close the second switch 126 during the fourth phase of the received signal 80. Moreover, the shunt capacitor 124 may receive electrical currents and/or charges of the fourth phase of the received signal 80. The inverse Q clock signal 92-4 may open the first switch 116 and the Q clock signal 92-2 may close the second switch 132 during a subsequent second phase of the received signal 80. The shunt capacitor 124 may output the stored electrical currents and/or charges of the fourth phase of the received signal 80. As such, the third switched-capacitor mixer and the fourth switched-capacitor mixer may generate the differential Q baseband signals 89-2 with the baseband frequency. Accordingly, the mixer 88 may generate the baseband signals 89 with the baseband frequency by folding and/or aliasing the received signal 80 based on sampling the received signal 80 using the quadrature clock signals 92 having the baseband frequency.

The baseband processor 90 may convert the baseband signals 89 to a digital signal of the incoming data 98 to be further processed by the electronic device 10. The baseband processor 90 may include any viable circuitry or component to convert the differential I baseband signals 89-1 to a digital signal of differential I incoming data 98-1 and to convert the differential Q baseband signals 89-2 to a digital signal of differential Q incoming data 98-2. For example, the baseband processor 90 may a first baseband processing stage 90-1, a second baseband processing stage 90-2, a third baseband processing stage 90-3, and a fourth baseband processing stage 90-4.

In the depicted embodiment, the first baseband processing stage 90-1 may be coupled to the second switch 126 of the first switched-capacitor mixer. Moreover, the second baseband processing stage 90-2 may be coupled to the second switch 128 of the second switched-capacitor mixer. The third baseband processing stage 90-3 may be coupled to the second switch 130 of the third switched-capacitor mixer. The fourth baseband processing stage 90-4 may be coupled to the second switch 132 of the fourth switched-capacitor mixer. The first baseband processing stage 90-1 and the second baseband processing stage 90-2 may generate the differential I incoming data 98-1. The third baseband processing stage 90-3 and the fourth baseband processing stage 90-4 may generate the differential Q incoming data 98-2. The baseband processor 90 may provide the differential I incoming data 98-1 and the differential Q incoming data 98-2 to any viable circuitry and/or component of the electronic device 10 for further processing.

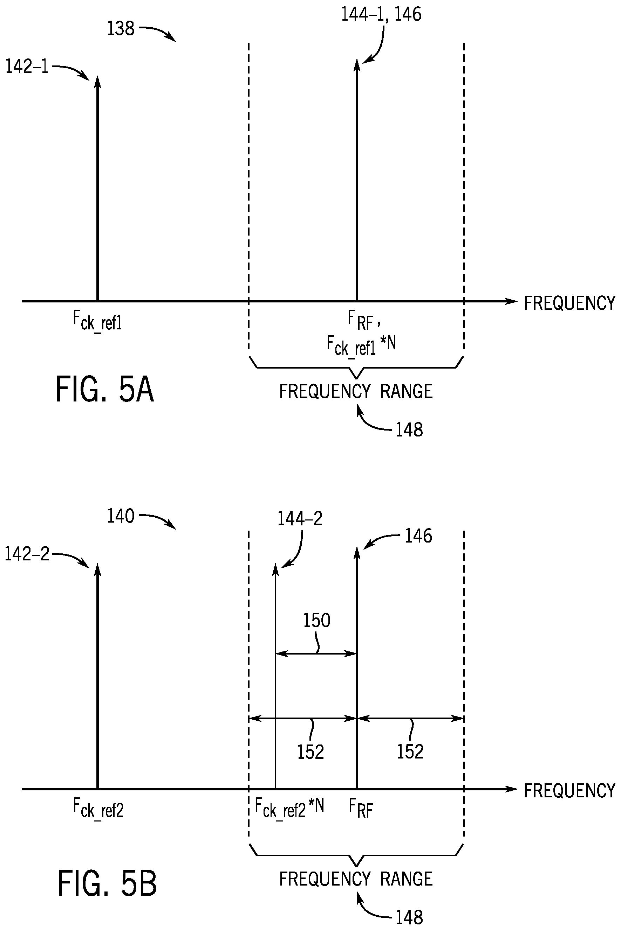

FIG. 5A is a first frequency spectrum diagram 138 illustrating a first baseband frequency 142-1 (e.g., the second frequency, F_{ck_ref1}) of the quadrature clock signals 92 where an odd multiple of the first baseband frequency 144-1 (e.g., a third frequency, N*F_{ck_ref1}) aligns with a radio frequency 146 of the received signal 80, according to embodiments of the present disclosure. For example, the mixer 88 may fold and/or alias the received signal 80 using the first baseband frequency 142-1 instead of the radio frequency 146 to generate lower frequency baseband signals 89. As such, the receiver 54 may convert the received signal 80 having the radio frequency 146 to baseband signals 89 having the lower first baseband frequency 142-1 by sampling the received signal 80 with an odd division clock frequency of the radio frequency.

As mentioned above, an odd multiple of the quadrature clock signals 92 may approximately or nearly align with an odd multiple of quadrature phases of the received signal 80. For example, in alternative or additional cases, the quadrature clock signals 92 may have a baseband frequency such that an odd multiple of the baseband frequency falls within a frequency range 148 centered around or in relative proximity of the radio frequency 146 of the received signal 80.

FIG. 5B is a second frequency spectrum diagram 140 illustrating a second baseband frequency 142-2 (e.g., the second frequency, F_{ck_ref1}) of the quadrature clock signals 92 where an odd multiple of the second baseband frequency 144-2 (e.g., a third frequency, N*F_{ck_ref1}) falls within the frequency range 148 of the radio frequency 146 of the received signal 80, according to embodiments of the present disclosure. As such, the odd multiple of the second baseband frequency 144-2 may have a frequency difference 150 with respect to the radio frequency 146 that is equal to or less than a threshold frequency range 152. The threshold frequency range 152 may correspond to half of a length of the frequency range 148. For example, the mixer 88 may convert, fold, or alias the received signal 80 using the second baseband frequency 142-2 instead of the radio frequency 146 to generate lower frequency baseband signals 89. As such, the receiver 54 may convert the received signal 80 having the radio frequency 146 to baseband signals 89 having the lower second baseband frequency 142-2 by sampling the received signal 80 with an odd division clock frequency of the radio frequency.

In some cases, the odd multiple of the second baseband frequency 144-2 may be an acceptable sampling frequency of the received signal 80 with the radio frequency 146 based on being within the frequency range 148. By way of example, the frequency range 148 may have a range of 0.1 MHz, 1.3 MHz, 20 MHz, 154 MHz, 1 GHz, and so on, among other possibilities around or centered around the radio frequency 146. Moreover, the threshold frequency range 152 may have a range of 0.05 MHz, 0.65 MHz, 10 MHz, 77 MHz, 0.5 GHz, and so on, among other possibilities from the radio frequency 146 (e.g., in a positive or negative direction). In such cases, the second baseband frequency 142-2 may correspond to an odd multiple of the second baseband frequency 144-2 that is within 0.1 MHz, 1.3 MHz, 20 MHz, 154 MHz, 1 GHz of the radio frequency 146.

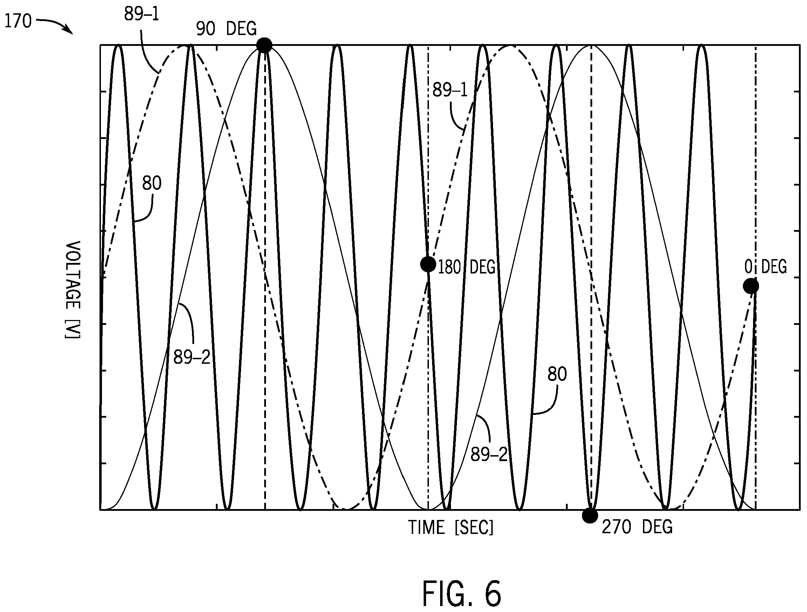

FIG. 6 is a timing diagram 170 of folded received signal 80 (e.g., the baseband signals 89) to a lower frequency by the mixer 88 based on sampling the received signal 80 with an odd division clock frequency of the radio frequency, according to embodiments of the present disclosure. As mentioned above, the quadrature clock signals 92 (not shown for simplicity) may align with (e.g., approximately or nearly align with) an odd multiple of quadrature phases of the received signal 80 based on the odd ratio (e.g., nearly odd ratio, approximately odd ratio, N) between the radio frequency and the baseband frequency. As such, the differential I baseband signals 89-1 may be sampled from the first phase (e.g., 0 degrees, approximately 0 degrees) and the third phase (e.g., 180 degrees, approximately 180 degrees) of the received signal 80. Similarly, the differential Q signals 89-2 may be sampled from the second phase (e.g., 90 degrees, approximately 90 degrees) and the fourth phase (e.g., 270 degrees, approximately 270 degrees) of the received signal 80. Accordingly, the mixer 88 and/or the receiver 54 may generate the differential I baseband signals 89-1 and the differential Q baseband signals 89-2 based on the sampling the received signal 80 with an odd division clock frequency of the radio frequency.

The specific embodiments described above have been shown by way of example, and it should be understood that these embodiments may be susceptible to various modifications and alternative forms. It should be further understood that the claims are not intended to be limited to the particular forms disclosed, but rather to cover all modifications, equivalents, and alternatives falling within the spirit and scope of this disclosure.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...," it is intended that such elements are to be interpreted under 35 U.S.C. 112(f). However, for any claims containing elements designated in any other manner, it is intended that such elements are not to be interpreted under 35 U.S.C. 112(f).

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

Exemplary embodiments are set out in the following items:
1. An electronic device comprising:
   an antenna configured to receive a signal having a first frequency; and
   a mixer coupled to the antenna, the mixer configured to
      receive a plurality of clock signals having a second frequency less than the first frequency, wherein a third frequency is an odd multiple of the second frequency, and the third frequency is within a threshold frequency range from the first frequency, and
      generate a plurality of baseband signals having the second frequency based on the signal and the plurality of clock signals.
2. The electronic device of item 1, wherein the mixer is configured to generate the plurality of baseband signals by sampling the signal based on the plurality of clock signals.
3. The electronic device of any of items 1-2, comprising a multi-phase delay-locked loop (MDLL) coupled to the mixer, the MDLL configured to generate the plurality of clock signals based on a reference clock signal.
4. The electronic device of any of items 1-3, wherein the plurality of clock signals comprise an in-phase clock signal and a quadrature clock signal.
5. The electronic device of item 4, wherein the mixer comprises an in-phase switched-capacitor mixer configured to receive the in-phase clock signal and a quadrature switched-capacitor mixer configured to receive the quadrature clock signal.
6. The electronic device of item 5, wherein the plurality of baseband signals comprise an in-phase baseband signal and a quadrature baseband signal, the in-phase switched-capacitor mixer configured to generate the in-phase baseband signal based on the signal and the in-phase clock signal and the quadrature switched-capacitor mixer configured to generate the quadrature baseband signal based on the signal and the quadrature clock signal.
7. The electronic device of item 6, wherein the in-phase switched-capacitor mixer is configured to generate the in-phase baseband signal by sampling the signals based on the in-phase clock signal.
8. The electronic device of any of items 6-7, wherein the quadrature switched-capacitor mixer is configured to generate the quadrature baseband signal by sampling the signals based on the quadrature clock signal.
9. The electronic device of any of items 1-8, comprising a baseband processor coupled to the mixer, the baseband processor configured to generate a digital signal of incoming data based on the plurality of baseband signals.
10. A receiver comprising:
   a multi-phase delay-locked loop (MDLL) configured to generate a plurality of clock signals having a first frequency; and
   a mixer coupled to the MDLL, the mixer configured to receive the plurality of clock signals and a signal having a second frequency from an antenna, the mixer configured to generate a plurality of baseband signals having the first frequency based on the signal and the plurality of clock signals, wherein a third frequency is an odd multiple of the first frequency, the third frequency is within a threshold frequency range from the second frequency, and the second frequency is greater than the first frequency.
11. The receiver of item 10, wherein the mixer is configured to generate the plurality of baseband signals by sampling the signal based on the plurality of clock signals.
12. The receiver of any of items 10-11, wherein the plurality of clock signals comprise an in-phase clock signal and a quadrature clock signal.
13. The receiver of item 12, wherein the mixer comprises an in-phase switched-capacitor mixer configured to receive the in-phase clock signal and a quadrature switched-capacitor mixer configured to receive the quadrature clock signal.
14. The receiver of item 13, wherein the plurality of baseband signals comprise an in-phase baseband signal and a quadrature baseband signal, the in-phase switched-capacitor mixer configured to generate the in-phase baseband signal based on the signal and the in-phase clock signal and the quadrature switched-capacitor mixer configured to generate the quadrature baseband signal based on the signal and the quadrature clock signal.
15. A mixer comprising:
   a multi-phase delay-locked loop (MDLL) configured to generate a first clock signal and a second clock signal having a first frequency;
   an in-phase switched-capacitor mixer coupled to the MDLL, the in-phase switched-capacitor mixer configured to receive the first clock signal and a signal from an antenna, the signal having a second frequency greater than the first frequency, the in-phase switched-capacitor mixer configured to generate an in-phase baseband signal having the first frequency based on the signal and the first clock signal; and
   a quadrature switched-capacitor mixer coupled to the MDLL, the quadrature switched-capacitor mixer configured to receive the second clock signal and the signal, the quadrature switched-capacitor mixer configured to generate a quadrature baseband signal having the first frequency based on the signal and the second clock signal.
16. The mixer of item 15, wherein the in-phase switched-capacitor mixer is configured to generate the in-phase baseband signal by sampling the signal based on the first clock signal.
17. The mixer of any of items 15-16, wherein the quadrature switched-capacitor mixer is configured to generate the quadrature baseband signal by sampling the signal based on the second clock signal.
18. The mixer of any of items 15-17, wherein the second clock signal is 90 degrees phase-delayed compared to the first clock signal.
19. The mixer of any of items 15-18, wherein a third frequency is an odd multiple of the first frequency, and the third frequency is within a threshold frequency range from the first frequency.
20. The mixer of any of items 15-19, wherein the second frequency is an odd multiple of the first frequency.

## Claims

1. An electronic device comprising:
an antenna configured to receive a signal having a first frequency; and
a mixer coupled to the antenna, the mixer configured to
receive a plurality of clock signals having a second frequency less than the first frequency, wherein a third frequency is an odd multiple of the second frequency, and the third frequency is within a threshold frequency range from the first frequency, and
generate a plurality of baseband signals having the second frequency based on the signal and the plurality of clock signals.

2. The electronic device of claim 1, wherein the mixer is configured to generate the plurality of baseband signals by sampling the signal based on the plurality of clock signals.

3. The electronic device of any of claims 1-2, comprising a multi-phase delay-locked loop (MDLL) coupled to the mixer, the MDLL configured to generate the plurality of clock signals based on a reference clock signal.

4. The electronic device of any of claims 1-3, wherein the plurality of clock signals comprise an in-phase clock signal and a quadrature clock signal.

5. The electronic device of claim 4, wherein the mixer comprises an in-phase switched-capacitor mixer configured to receive the in-phase clock signal and a quadrature switched-capacitor mixer configured to receive the quadrature clock signal.

6. The electronic device of claim 5, wherein the plurality of baseband signals comprise an in-phase baseband signal and a quadrature baseband signal, the in-phase switched-capacitor mixer configured to generate the in-phase baseband signal based on the signal and the in-phase clock signal and the quadrature switched-capacitor mixer configured to generate the quadrature baseband signal based on the signal and the quadrature clock signal.

7. The electronic device of claim 6, wherein the in-phase switched-capacitor mixer is configured to generate the in-phase baseband signal by sampling the signals based on the in-phase clock signal.

8. The electronic device of any of claims 6-7, wherein the quadrature switched-capacitor mixer is configured to generate the quadrature baseband signal by sampling the signals based on the quadrature clock signal.

9. The electronic device of any of claims 1-8, comprising a baseband processor coupled to the mixer, the baseband processor configured to generate a digital signal of incoming data based on the plurality of baseband signals.
